# EUROPÄISCHE PATENTSCHRIFT

(11) **EP 1 311 043 B1**
(45) Veröffentlichungstag und Bekanntmachung des Hinweises auf die Patenterteilung: **30.07.2008**
(21) Anmeldenummer: 02022165.1
(22) Anmeldetag: 03.10.2002
(51) Int. Cl.: H02G 3/22, H05K 9/00

(54) **Kabeldurchführung durch eine Schirmungswand**
Cable passage through a shielding wall
Traversée ce câble à travers une paroi blindée

(30) Priorität: 12.11.2001 DE 10155434
(43) Veröffentlichungstag der Anmeldung: 14.05.2003
(73) Patentinhaber: SIEMENS AKTIENGESELLSCHAFT, 80333 München (DE)
(72) Erfinder: Buchberger, Georg, 80689 Muenchen (DE)
(74) Vertreter: Maier, Daniel Oliver

(56) Entgegenhaltungen:
- EP-A- 0 134 163

## Beschreibung

Bei einer Entwicklung von elektrischen Geräten mit hoher Aufbaudichte und sehr hohen Arbeitsfrequenzen und aufgrund der damit einhergehenden Zunahme von elektromagnetischen Störfeldern innerhalb und außerhalb der elektrischen Geräte, gewinnt eine elektromagnetische Abschirmung von Geräten oder Baugruppen zunehmend an Bedeutung.

Zur elektromagnetischen Abschirmung sind im Allgemeinen Schirmungsgehäuse oder Schirmungswände vorgesehen. In derartigen Schirmungsgehäusen oder Schirmungswänden sind jedoch in aller Regel Öffnungen zur Durchführung von Kabeln erforderlich, wodurch die Schirmwirkung beeinträchtigt wird. Im Allgemeinen sind verhältnismäßig große Öffnungen vorzusehen, um mit einem Kabel auch einen im Verhältnis zum Kabeldurchmesser großen Kabelstecker durchführen zu können. Je größer die Öffnung ist, desto mehr verringert sich allerdings auch die Schirmwirkung. Für die Verringerung der Schirmwirkung ist bei Rundöffnungen im Wesentlichen deren Durchmesser und bei Rechtecköffnungen im Wesentlichen deren Diagonale maßgeblich. Es stellt sich somit das Problem, eine derartige Öffnung einerseits groß genug zur bequemen Durchführung von Kabelsteckern und andererseits klein genug zur Erhaltung einer ausreichenden Schirmwirkung zu bemessen.

In der Praxis werden ursprünglich groß bemessene Öffnungen häufig mittels Abdeckungen, die nach Durchführung eines Kabels zu montieren sind, nachträglich verkleinert. Dies erfordert jedoch zusätzlichen Material- und Montageaufwand.

Aus der EP 0 134 163 A1 ist eine Koaxialkabeldurchführung in einer Trennwand bekannt, die aus vier bogenförmig ausgebildeten Abschnitten besteht, welche aus einer Schirmungswand geprägt sind. Diese bogenförmigen Abschnitte bilden jeweils eine Rundöffnung. Die bogenförmigen Abschnitte sind rigide, wodurch der Durchmesser der Rundöffnung starr vorgegeben und auf den Durchmesser des durchzuführenden Kabels abgestimmt ist. Ein Kabel mit größerem Durchmesser oder ggf. mit einem endseitig angeschlagenen Stecker kann überhaupt nicht hindurchgeführt werden.

Es ist Aufgabe der vorliegenden Erfindung eine einfach herzustellende Kabeldurchführung anzugeben, die hinsichtlich der Größe des durchzuführenden Kabels flexibel ist, die eine gute Schirmwirkung aufweist und nur geringen Montageaufwand beim Durchführen eines Kabels erfordert.

Gelöst wird diese Aufgabe durch eine Kabeldurchführung mit den Merkmalen des Patentanspruchs 1. Vorteilhafte Ausführungsformen und Weiterbildungen der Erfindung sind in den abhängigen Ansprüchen angegeben.

Die erfindungsgemäße Kabeldurchführung weist Kontaktierungs- und Befestigungsmittel auf, die durch biegsame, elektrisch leitende Befestigungslaschen gebildet sind, welche eine am Kabel anliegende Kabelschirmung jeweils an voneinander getrennt liegenden Kontaktierung stellen kontaktieren, so dass eine elektrisch leitende Überbrückung der Öffnungsrändern hergestellt ist. Durch die biegsame Ausführung der Kontaktierung- und Befestigungslaschen kann die Öffnung insgesamt kleiner bemessen sein, was sich vorteilhaft für die Schirmwirkung auswirkt; das Durchführen oder Montieren eines oder mehrerer Kabel wird erleichtert.

In einer bevorzugten Ausführungsform können die Befestigungslaschen einstückig, zum Beispiel durch Ausstanzen, aus der Schirmungswand ausgeformt sein. Alternativ dazu können nachträglich am Öffnungsrand befestigte Befestigungslaschen vorgesehen sei, die zum Beispiel aus dünnerem und biegsame Blech als die Schirmungswand bestehen.

Nach einer vorteilhaften Ausführungsform der Erfindung können die Kontaktierungs- und Befestigungsmittel dergestalt angeordnet sein, dass das montierte Kabel im Wesentlichen der Länge nach die beiden gegenüberliegenden Öffnungsränder verbindet. Auf diese Weise können auch größere Öffnungen durch das Kabel überbrückt werden.

Weiterhin können Kabelbinder zum Anbinden des Kabels an den Befestigungslaschen beider gegenüberliegenden Öffnungsränder als Befestigungsmittel vorgesehen sei. Die Befestigungslaschen können hierbei vorzugsweise mit vorspringenden Nasen oder Haken versehen sein, um ein Abrutschen der Kabelbinder zu erschweren.

Weiterhin können die Kontaktierungs- und Befestigungsmittel an einem ersten der gegenüberliegenden Öffnungsränder zum Kontaktieren und Befestigen des Kabels an einer Vorderseite der Schirmungswand und an einem zweiten der gegenüberliegenden Öffnungsränder zum Kontaktieren und Befestigen des Kabels an einer Rückseite der Schirmungswand ausgebildet sei. Auf diese Weise kann das Kabel schräg durch die Öffnung geführt werden.

Nach einer vorteilhaften Weiterbildung der Erfindung kann zwischen den gegenüberliegenden Öffnungsrändern mindestens ein ausbrechbarer Verbindungssteg zur Abschirmung eines nicht zur Durchführung eines Kabels genutzten Teils der Öffnung angeordnet sei. Vorzugsweise kann der Verbindungssteg zwischen Befestigungslaschen angeordnet sein und weiterhin mit diesen über eine Sollbruchstelle verbunden sei.

Ein Ausführungsbeispiel der Erfindung wird nachfolgend anhand der Zeichnung näher erläutert.

Dabei zeigen:
Fig 1 eine unbenutzte Kabeldurchführung in Draufsicht,
Fig 2 die Kabeldurchführung mit einem durchgeführtem Kabel in Draufsicht,
Fig 3 die Kabeldurchführung mit durchgeführtem Kabel in Seitenansicht, und
Fig 4 eine Seitenansicht der Kabeldurchführung beim Durchführen eines Kabels.

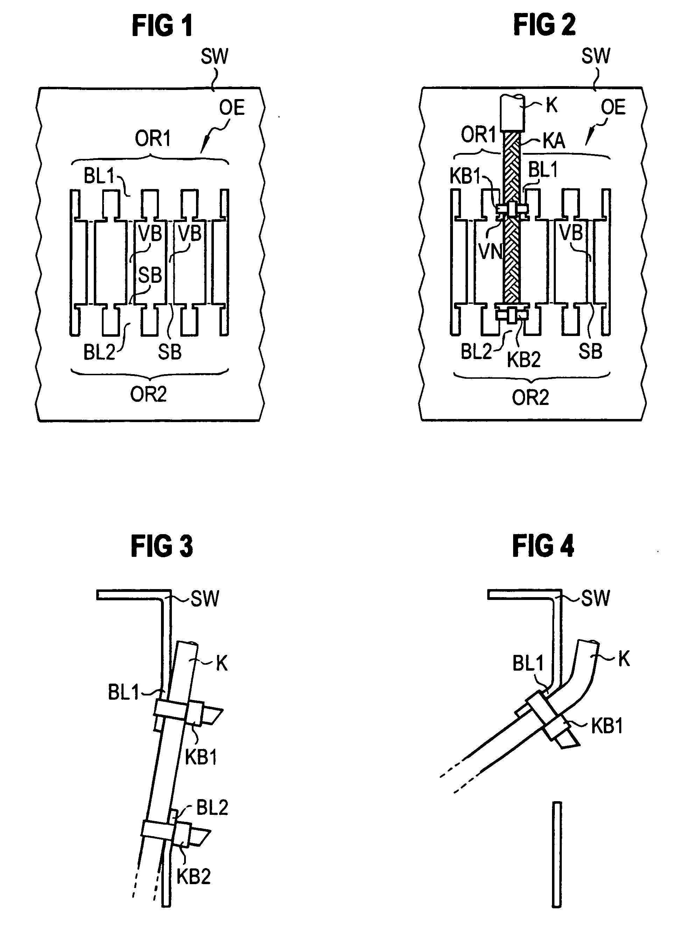

Die **Figuren 1 und 2** zeigen jeweils eine Draufsicht auf eine Schirmungswand SW, z.B. eine Rückwand eines metallischen Gerätegehäuses mit einer Öffnung OE zur Durchführung von Kabeln. Die Öffnung OE ist an zwei gegenüberliegenden Öffnungsrändern OR1 und OR2 mit in die Öffnung OE hineinragenden Befestigungslaschen BL1 und BL2 versehen, die elektrisch leitend und biegsam sind. Im vorliegenden Ausführungsbeispiel sind am Öffnungsrand OR1 vier Befestigungslaschen BL1 und am Öffnungsrand OR2 vier, den Befestigungslaschen BL1 gegenüberliegende Befestigungslaschen BL2 vorgesehen. Aus Gründen der Übersichtlichkeit sind nur zwei gegenüberliegende Befestigungslaschen BL1 und BL2 mit einem Bezugszeichen versehen. Die Öffnung OE ist so groß bemessen, dass vier Kabel nebst zugehörigen Kabelsteckern durchgeführt werden können. Insbesondere ist der Abstand gegenüberliegender Befestigungslaschen BL1 und BL2 deutlich größer als ein Kabeldurchmesser der durchzuführenden Kabel.

**Figur 1** zeigt eine unbenutzte Kabeldurchführung, bei der kein Kabel durch die Öffnung OE durchgeführt ist. In diesem Fall sind jeweils gegenüberliegende Befestigungslaschen BL1 und BL2 durch ausbrechbare Verbindungsstege VB elektrisch leitend verbunden. Durch die leitende Verbindung der gegenüberliegenden Befestigungslaschen BL1 und BL2 wird die für die Beeinträchtigung der Schirmwirkung maßgebliche Diagonale der Öffnung OE verkleinert.

Zwischen den Verbindungsstegen VB und den Befestigungslaschen BL1 und BL2 sind jeweils Sollbruchstellen SB vorgesehen, um einen jeweiligen Verbindungssteg VB bei Bedarf, d.h. bei Durchführung eines Kabels auf bequeme Weise ausbrechen zu können.

Aus Übersichtlichkeitsgründen sind in den Figuren 1 und 2 nur einige der Verbindungsstege VB und Sollbruchstellen SB durch ein Bezugszeichen gekennzeichnet.

**Figur 2** zeigt die Kabeldurchführung nach Durchführung und Befestigung eines Kabels K. Das Kabel K ist an zwei gegenüberliegenden Befestigungslaschen BL1 und BL2 befestigt, zwischen denen vorher der Verbindungssteg VB ausgebrochen wurde. Im Folgenden werden die Bezugszeichen BL1 und BL2 nur noch für diejenigen Befestigungslaschen BL1 und BL2 benutzt, an denen das Kabel K befestigt ist. Eine Kabelabschirmung KA des Kabels K ist durch Entfernen einer Kabelisolierung auf einer Länge, die etwa dem Abstand der Öffnungsränder OR1 und OR2 bzw. der gegenüberliegenden Befestigungslaschen BL1 und BL2 entspricht, freigelegt. Das Kabel K ist im Bereich der freigelegten Kabelabschirmung KA durch einen Kabelbinder KB1 an der Vorderseite der Befestigungslasche BL1 und durch einen Kabelbinder KB2 an der Rückseite der Befestigungslasche BL2 festgebunden. Vorder- und Rückseite der Befestigungslaschen BL1 und BL2 beziehen sich hierbei auf die Vorder- und Rückseite der Schirmungswand SW. Die freigelegte Kabelabschirmung KA wird durch die festgezogenen Kabelbinder KB1 und KB2 an die Befestigungslaschen BL1 bzw. BL2 gedrückt. Da die Befestigungslaschen BL1 und BL2 leitend sind, wird die Kabelabschirmung KA an voneinander getrennten Kontaktierungsstellen durch Berührung der Befestigungslaschen BL1 und BL2 kontaktiert. Außer dem Freilegen der Kabelabschirmung KA ist dazu keine weitere Behandlung der Kabelabschirmung KA oder des Kabels erforderlich. Die betreffenden Befestigungslaschen BL1 und BL2 fungieren somit sowohl als Befestigungs- als auch als Kontaktierungsmittel für das Kabel K. Eine jeweilige Kontaktierungsstelle befindet sich bei der Befestigungslasche BL1 auf deren Vorderseite und bei der Befestigungslasche BL2 auf deren Rückseite.

Die Kabelabschirmung KA des befestigten Kabels K verbindet die gegenüberliegenden Befestigungslaschen BL1 und BL2 bzw. die gegenüberliegenden Öffnungsränder OR1 und OR2 anstelle des herausgebrochenen Verbindungssteges elektrisch leitend. Auf diese Weise wird eine Vergrößerung der für die Beeinträchtigung der Schirmwirkung maßgeblichen Öffnungsdiagonale vermieden. Die Abschirmfunktion des herausgebrochenen Verbindungssteges wird somit durch den die Öffnung OE überbrückenden Abschnitt der Kabelabschirmung KA übernommen.

Die Befestigungslaschen BL1 und BL2 sind öffnungsseitig mit vorspringenden Nasen VN versehen, um zu verhindern, dass die das Kabel K befestigenden Kabelbinder KB1 und KB2 von den Befestigungslaschen BL1 und BL2 abrutschen

**Figur 3** zeigt eine Seitenansicht der Kabeldurchführung mit durchgeführtem Kabel K. Die hierin angegebenen Bezugszeichen haben jeweils die gleiche Bedeutung wie in allen anderen Figuren. Figur 3 veranschaulicht die schräge Kabelführung des Kabels K durch die Öffnung OE. Die schräge Kabelführung wird durch die Biegsamkeit der Befestigungslaschen BL1 und BL2 begünstigt, die - parallel am Kabel K anliegend - leicht gebogen werden.

**Figur 4** zeigt schließlich eine Seitenansicht der Kabeldurchführung beim Durchführen des Kabels K. Zum Durchführen des Kabels K wird dieses zunächst mit dem Kabelbinder KB1 an der Vorderseite der Befestigungslasche BL1 festgebunden. Das Durchführen und Festbinden des Kabels K wird dabei durch die Biegsamkeit der Befestigungslasche BL1 - wie in Figur 4 angedeutet - wesentlich erleichtert. Aufgrund der biegsamen Befestigungslaschen BL1 und BL2 kann die Öffnung OE insgesamt kleiner bemessen sein, was sich vorteilhaft auf die Schirmwirkung auswirkt. Nach dem Festbinden des Kabels K an der Befestigungslasche BL1 wird das Kabel K, wie in den Figuren 2 und 3 dargestellt auch an der Befestigungslasche BL2 durch den Kabelbinder KB2 festgebunden.

## Patentansprüche

1. Kabeldurchführung durch eine Öffnung (OE) einer Schirmungswand (SW), mit Kontaktierungsmittel (BL1, BL2) und Befestigungsmittel (KB1, KB2, BL1, BL2) zum Kontaktieren und Befestigen desselben durchzuführenden Kabels (K) an zwei einander gegenüberliegenden Öffnungsrändern (OR1, OR2),
**dadurch gekennzeichnet,**
- **dass** die Kontaktierungs- und Befestigungsmittel (BL1, BL2, KB1, KB2) durch biegsame, elektrisch leitende Befestigungslaschen (BL1, BL2) gebildet sind, welche eine am Kabel (K) anliegende Kabelabschirmung (KA) jeweils an voneinander getrennt liegenden Kontaktierungsstellen kontaktieren, so dass eine elektrisch leitende Überbrückung der Öffnungsränder (OR1, OR2) hergestellt ist.

2. Kabeldurchführung nach Anspruch 1,
**dadurch gekennzeichnet,**
**dass** die Befestigungslaschen (BL1, BL2) einstückig aus der Schirmungswand (SW) ausgeformt sind.

3. Kabeldurchführung nach Anspruch 1 oder 2,
**dadurch gekennzeichnet,**
**dass** die Befestigungslaschen (BL1, BL2) dergestalt angeordnet sind, dass das Kabel (K) im Wesentlichen der Länge nach die beiden gegenüberliegenden Öffnungsränder (OR1, OR2) verbindet.

4. Kabeldurchführung nach einem der Ansprüche 1, 2 oder 3,
**dadurch gekennzeichnet,**
**dass** Kabelbinder (KB1, KB2) zum Anbinden des Kabels (K) an den Befestigungslaschen (BL1, BL2) beider gegenüberliegenden Öffnungsränder (OR1, OR2) als Befestigungsmittel vorgesehen sind.

5. Kabeldurchführung nach einem der vorhergehenden Ansprüche,
**dadurch gekennzeichnet,**
**dass** die Kontaktierungs- und Befestigungsmittel (BL1, BL2, KB1, KB2) an einem ersten der gegenüberliegenden Öffnungsränder (OR1) zum Kontaktieren und Befestigen des Kabels (K) an einer Vorderseite der Schirmungswand (SW) und
an einem zweiten der gegenüberliegenden Öffnungsränder (OR2) zum Kontaktieren und Befestigen des Kabels (K) an einer Rückseite der Schirmungswand (SW) ausgebildet sind.

6. Kabeldurchführung nach einem der vorhergehenden Ansprüche,
**gekennzeichnet durch**
mindestens einen zwischen den gegenüberliegenden Öffnungsrändern (OR1, OR2) angeordneten, ausbrechbaren Verbindungssteg (VB) zur Abschirmung eines nicht zur Durchführung eines Kabels (K) genutzten Teils der Öffnung (OE).

## Claims

1. Cable passage through an opening (OE) in a shielding wall (SW), having contacting means (BL1, BL2) and attachment means (KB1, KB2, BL1, BL2) for making contact with and attaching the same cable (K) to be passed through, arranged on two mutually opposite opening edges(OR1, OR2),
**characterised in that**
- the contacting and attachment means (BL1, BL2, KB1, KB2) are formed by pliable, electrically conductive attachment lugs (BL1, BL2), which make contact with a cable shield (KA) adjacent to the cable (K) at separate contacting points respectively, so that the opening edges (OR1, OR2) are bridged in an electrically conductive manner.

2. Cable passage according to claim 1,
**characterised in that** the attachment lugs (BL1, BL2) are formed as a single piece from the shielding wall (SW).

3. Cable passage according to claim 1 or 2,
**characterized in that** the attachment lugs (BL1, BL2) are arranged such that the cable (K) essentially connects the two opposite opening edges (OR1, OR2), according to its length.

4. Cable passage according to one of claims 1, 2 or 3,
**characterized in that** cable ties (KB1, KB2) are provided to tie the cable (K) to the attachment lugs (BL1, BL2) of the two opposite opening edges (OR1, OR2).

5. Cable passage according to one of the preceding claims,
**characterised in that** the contacting and attachment means (BL1, BL2, KB1, KB2) are configured on a first of the opposite opening edges (OR1) to make contact with and attach the cable (K) to a front face of the shielding wall (SW) and
are configured on a second of the opposite opening edges (OR2) to make contact with and attach the cable (K) to a rear face of the shielding wall (SW).

6. Cable passage according to one of the preceding claims,
**characterised by**
at least one connecting web (VB), which can be knocked out, arranged between the opposite opening edges (OR1, OR2), to shield a part of the opening (OE) which is not used for the passage of a cable (K).

## Revendications

1. Traversée de câble à travers un orifice (OE) d'une paroi de blindage (SW) avec des moyens de contact (BL1, BL2) et des moyens de fixation (KB1, KB2, BL1, BL2) pour connecter et fixer au niveau de deux bords opposés de l'orifice (OR1, OR2) le même câble (K) à faire passer, **caractérisée en ce que** les moyens de contact et de fixation (BL1, BL2, KB1, KB2) sont constitués par des pattes de fixation (BL1, BL2) électroconductrices flexibles qui établissent un contact avec un blindage de câble (KA) adjacent au câble (K) respectivement à des points de contact séparés l'un de l'autre de sorte qu'un pontage électroconducteur des bords de l'orifice (OR1, OR2) est réalisé.

2. Traversée de câble selon la revendication 1, **caractérisée en ce que** les pattes de fixation (BL1, BL2) sont réalisées d'une seule pièce à partir de la paroi de blindage (SW).

3. Traversée de câble selon la revendication 1 ou 2, **caractérisée en ce que** les pattes de fixation (BL1, BL2) sont disposées de manière telle que le câble (K) relie les deux bords opposés de l'orifice sensiblement dans le sens de la longueur.

4. Traversée de câble selon l'une des revendications 1, 2 ou 3, **caractérisée en ce que** sont prévus, en tant que moyens de fixation, des serre-câble (KB1, KB2) pour attacher le câble (K) aux pattes de fixation (BL1, BL2) des deux bords opposés de l'orifice (OR1, OR2).

5. Traversée de câble selon l'une des revendications précédentes, **caractérisée en ce que** les moyens de contact et de fixation (BL1, BL2, KB1, KB2) sont réalisés sur un premier des bords opposés de l'orifice (OR1) pour connecter et fixer le câble (K) à une face avant de la paroi de blindage (SW) et sur un deuxième des bords opposés de l'orifice (OR2) pour connecter et fixer le câble (K) à une face arrière de la paroi de blindage (SW).

6. Traversée de câble selon l'une des revendications précédentes, **caractérisée par** au moins une nervure de liaison (VB) arrachable située entre les bords opposés de l'orifice (OR1, OR2) aux fins du blindage d'une partie de l'orifice (OE) non utilisée pour le passage d'un câble (K).
